# EUROPÄISCHE PATENTSCHRIFT

(11) **EP 0 905 754 B1**
(45) Veröffentlichungstag und Bekanntmachung des Hinweises auf die Patenterteilung: **24.06.2009**
(21) Anmeldenummer: 98115931.2
(22) Anmeldetag: 24.08.1998
(51) Int. Cl.: H01L 21/3105, H01L 21/321, H01L 21/311, H01L 21/3213, C23F 3/06

(54) **Verfahren zum Planarisieren**
Planarization process
Procédé de planarisation

(30) Priorität: 30.09.1997 AT 165897
(43) Veröffentlichungstag der Anmeldung: 31.03.1999
(73) Patentinhaber: SEZ AG, 9500 Villach (AT)
(72) Erfinder: Kruwinus, Hans-Jürgen, Dipl.-Ing., 9551 Bodensdorf (Kärnten) (AT); Sellmer, Reinhard, Dipl.-Ing. (FH), 9500 Villach (Kärnten) (AT)
(74) Vertreter: Kontrus, Gerhard

(56) Entgegenhaltungen:
- EP-A- 0 699 782
- US-A- 4 992 135
- US-A- 5 019 205
- US-A- 5 486 234
- PATENT ABSTRACTS OF JAPAN vol. 1997, no. 01, 31. Januar 1997 (1997-01-31) -& JP 08 236615 A (UBE IND LTD), 13. September 1996 (1996-09-13)
- PATENT ABSTRACTS OF JAPAN vol. 014, no. 018 (E-873), 16. Januar 1990 (1990-01-16) -& JP 01 260829 A (FUJITSU LTD), 18. Oktober 1989 (1989-10-18)
- JING F ET AL: "CHEMICAL POLISHING OF COPPER" TRANSACTIONS OF THE INSTITUTE OF METAL FINISHING,GB,INSTITUTE OF METAL FINISHING. LONDON, Bd. 73, Nr. PART 04, 1. November 1995 (1995-11-01), Seiten 139-141, XP000542992 ISSN: 0020-2967
- UNVALA ET AL: "The produciton of clean, flat, strain-free germanium surfaces" JOURNAL OF SCIENTIFIC INSTRUMENTS., Bd. 2, Nr. 2, Januar 1969 (1969-01), Seiten 119-120, XP002151337 INSTITUTE OF PHYSICS. LONDON., GB

## Beschreibung

Die Erfindung betrifft ein Verfahren zum Planarisieren von Substraten der Halbleitertechnik durch Entfernen einer Schichte, die aus Metall, z.B. Kupfer oder Aluminium, oder aus einem anderen Stoff, wie polykristallinem Silizium, polykristallinen Siliziden oder Siliziumdioxid (SiO₂) bestehen kann, von Substraten der Halbleitertechnik.

Insbesondere bezieht sich das erfindungsgemäße Verfahren darauf, die genannte Beschichtung durch Planarisieren so abzutragen, daß die Schichte auf der Oberfläche des Halbleitersubstrates abgetragen, aber in Gräben oder Kontaktlöchern, die im Halbleitersubstrat vorgesehen sind, verbleibt, so daß dort Leiterbahnen oder isolierende Bahnen entstehen.

Das erfindungsgemäße Verfahren soll ohne vorhergehenden (mechanischen) Polierschritt in einem Schritt mit Hilfe eines flüssigen Ätzmediums ausgeführt werden können.

Aus der US 5 486 234 A ist ein Verfahren zum Entfernen von Metall, das sich einerseits auf der Oberfläche eines Substrates und anderseits in Gräben oder Kontaktlöchern in dem Substrat befindet, bekannt.

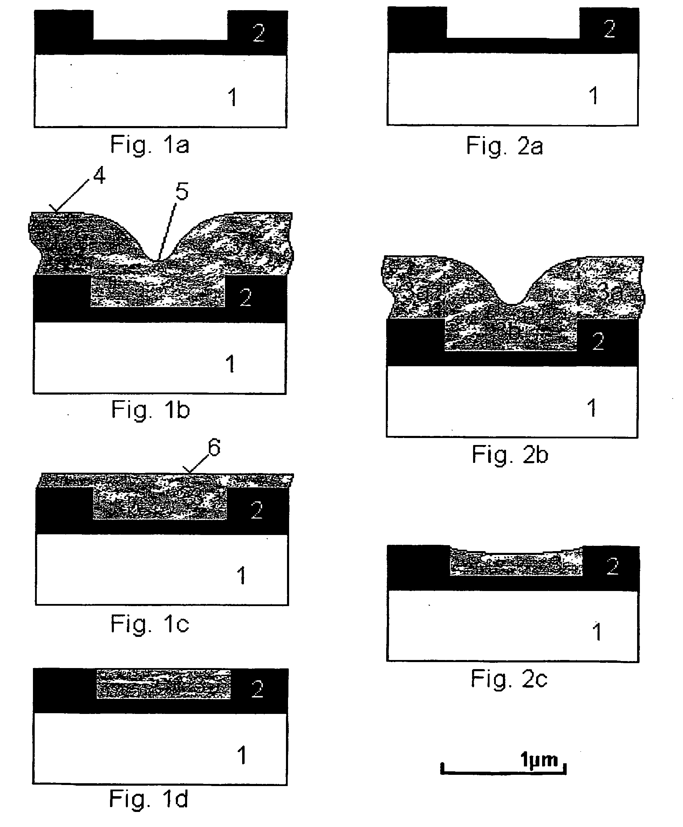

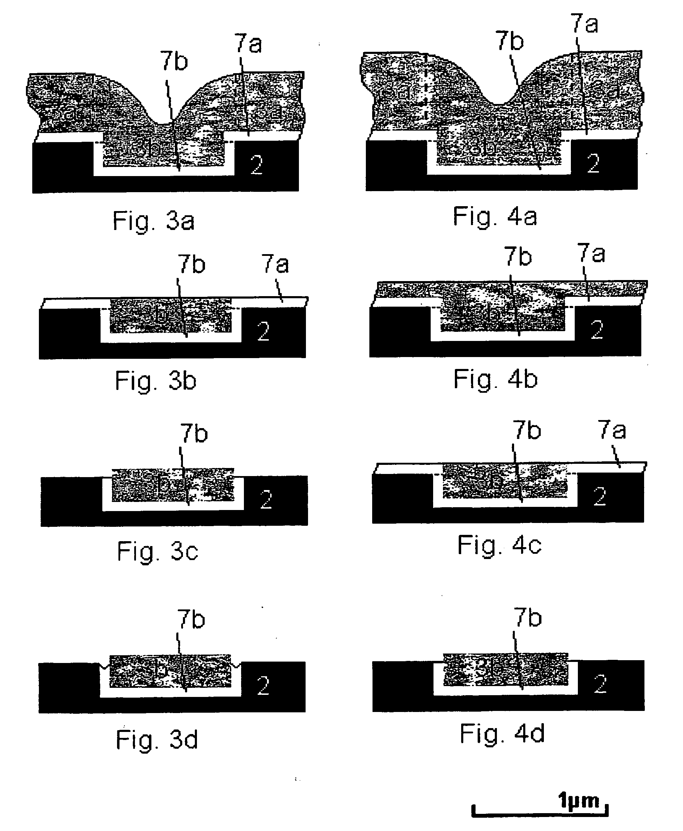

In den Fig. 1a bis 1d ist das aus der US 5 486 234 A bekannte Verfahren anhand eines schematischen Schnittes durch ein Halbleitersubstrat wiedergegeben. Fig. 1a zeigt ein Halbleitersubstrat 1,auf dem eine Isolatorschicht 2 (z.B. eine Schicht aus Siliziumdioxid, Si0₂) aufgebracht ist, in die mittels Lithografie Gräben geätzt worden sind, die später Leiterbahnen darstellen sollen. Auf diese Isolatorschicht 2 wird eine nicht dargestellte dünne Sperrschicht, z.B. aus Titan aufgebracht. Auf diese Sperrschicht wird anschließend eine Metallschicht 3 aufgebracht. Das Aufbringen der Metallschicht 3(siehe Fig. 1b) kann durch Elektroplattieren erfolgen. Die Oberfläche 4 der Metallschicht 3 zeigt Gräben 5, die bekannt sind, obwohl sie in Fig. 3 der US 5 486 234 A nicht dargestellt sind. Wird ein gleichmäßig wirkendes Ätzen angewendet, würden diese Gräben tiefer werden, so daß es nicht möglich ist, das angestrebte Endergebnis (Fig. 1d) zu erzielen, indem man das in Fig. 1b dargestellte Substrat einem gleichmäßigen Ätzverfahren unterwirft. Das bisher bekannte Metallätzverfahren (Sprühen, Auftropfen von Ätzmedien auf die Oberfläche eines rotierenden Halbleitersubstrates (Wafer) macht vielmehr einen Zwischenschritt erforderlich, um das meiste Metall der auf die Sperrschicht aufgebrachten Metallage 3 zu entfernen. Um sicherzustellen, daß noch vor dem Beginn des Ätzens eine ebene Oberfläche 6, wie sie in Fig. 1c dargestellt ist, vorliegt. Dieses Polieren (Einebnen) kann gemäß dem Vorschlag der US 5 486 234 A ein Elektropolieren sein.

Ein weiterer Nachteil des bekannten Sprüh- und Tropfenätzens ist es, daß nur niedrige Ätzraten (0,02 bis 1,34 µ/min) erreicht werden. Um hier mit vernünftigen Zeiten zu einem gewünschten Ergebnis zu kommen, ist es notwendig, einen Großteil des Metalls der Schicht 3 durch andere Verfahren (z.B. Elektropolieren) zu entfernen.

In der EP 0 223 920 B1 werden Plasmaätzen oder reaktives Ionenätzen mit Planarisierungsmitteln (z.B. SOG = spin on glass) als Planarisierungsmethode beschrieben. Insbesondere wird in der EP 0 223 920 B1 das an sich bekannte Verfahren des chemisch mechanischen Polierens als Verfahren zum Planarisieren vorgeschlagen.

Mit dem erfindungsgemäßen Verfahren für das Herstellen von Leiterbahnen oder Isolatorbahnen in einem Substrat der Halbleitertechnik soll ein Verfahren zur Verfügung gestellt werden, bei dem das beispielsweise durch Elektroplattieren aufgebrachte Metall oder ein anderes Material, das nach dem Auftragen eine nicht ebene Oberfläche und insbesondere im Bereich von Graben Vertiefungen bildet, durch einen einzigen Naßätzvorgang so entfernt werden, daß das Metall oder der andere Stoff von den Feldern vollständig, also bis zur Isolatorschicht 2 entfernt wird, in den Gräben oder den Kontaktlöchern aber nur so weit entfernt wird, daß eine im wesentlichen ebene Oberfläche entsteht.

Erfindungsgemäß wird diese Aufgabe durch ein Verfahren mit den Merkmalen des Anspruches 1 gelöst.

Bevorzugte und vorteilhafte Ausführungsformen des erfindungsgemäßen Verfahrens sind Gegenstand der Unteransprüche.

Mit der Erfindung ist es möglich, unterschiedliche Ätzraten über dem Feld 3a und über mit der Schicht 3 gefüllten Gräben 3b in der Isolatorschicht 2 zu gewährleisten, so daß ein rein naßchemsches Verfahren zur Verfügung gestellt wird, das zum Planarisieren geeignet ist.

Durch das erfindungsgemäße Verfahren wird erreicht, daß die Ätzrate bezüglich des Stoffes (Metall oder anderer Stoff) im Bereich der Felder zwischen den Gräben oder Kontaktlöchern wesentlich höher ist als die Ätzrate über den Gräben oder den Kontaktlöchern.

Von Vorteil ist dabei, daß das erfindungsgemäße Verfahren sehr einfach ausgeführt werden kann, da die Ätzflüssigkeit einfach in einen kontinuierlichen Fluß auf die Oberfläche des in Rotation versetzten Substrates der Halbleitertechnik (Wafer) gegossen werden braucht.

Vorteilhaft ist dabei, wenn das Ätzmedium mit einem Volumenstrom von über 0,4 l/min aufgebracht wird.

Wichtig ist es, daß auf der Oberfläche des Halbleitersubstrates keine Tropfenbildung auftritt, da diese zu einem unerwünschten Gleichmäßigätzen führen würde und die angestrebte Vergleichmäßigung (Planarisierung) der Oberfläche des Halbleitersubstrates verhindern würde.

Es ist überraschend, daß mit dem erfindungsgemäßen Verfahren die unterschiedlichen Ätzraten so erreicht werden, daß ein Planarisieren der Oberfläche bewirkt wird. Grund hiefür dürfte der Umstand sein, daß sich unmittelbar über der Oberfläche des Substrates eine Schicht ausbildet, in der das in einem kontinuierlichen Strom aufgebrachte Ätzmedium durch Reibung und Viskosität gegenüber dem Substrat nahezu stillsteht, und daß der Austausch der Reaktanten (Ätzmittel) einerseits und Ätzprodukte durch diese stillstehende Schicht anderseits nur langsam erfolgt, so daß in den tieferen Bereichen (also im Bereich von Gräben oder Kontaktlöchern) wegen der durch den längeren Diffusionsweg bedingten längeren Diffusionszeit und damit geringeren Ätzrate zum Abtragen langsam erfolgt als in den weniger tiefen Bereichen der stillstehenden Schichte, da dort der Stoffaustausch wesentlich rascher und mit weniger Zeitaufwand erfolgt. Am Beispiel des Ätzens von Kupfer mit Salpetersäure bedeutet dies, daß die Nitrationen (N0₃⁺), die an der Grenzfläche Ätzmedium-Kupfer verbraucht werden, nun durch Diffusion durch die sich nicht oder nur wenig bewegende, unmittelbar an die Grenzfläche angrenzende Schicht des Ätzmediums ersetzt werden können. Weiters wird im Fall des Beispiels Ätzen von Kupfer mit Salpetersäure im Bereich der unmittelbar über der Grenzfläche liegenden Ätzmediumschichte eine hohe Anreicherung von Wasserstoff, Kupferionen und NOₓ-Verbindungen auftreten, die ebenfalls die Ätzgeschwindigkeiten im Sinne einer Verringerung beeinflussen.

Je länger es dauert, bis diese Reaktionsprodukte aus der unmittelbar an die Grenzfläche anschließenden Schicht des Ätzmediums hinausdiffundieren und durch die oberen, sich bewegenden Bereiche abtransportiert werden, desto kleiner ist die Ätzrate im Bereich der Gräben als in dem Bereich der Stege bzw. Felder zwischen den Gräben.

Somit wird, wie dies in den Fig. 2a bis 2c gezeigt ist, erreicht, daß ausgehend von einem mit einer Beschichtung 3 versehenen Substrat 1, auf dem eine Isolatorschicht 2 aufgebracht ist, auf der noch eine Sperrschicht (nicht gezeigt) vorliegen kann, in einem einzigen Schritt eine Planarisierung erreicht wird, so daß das Material der Beschichtung 3 im Bereich 3a der Felder zwischen den Gräben zur Gänze abgetragen, im Bereich 3b der Gräben aber (wegen der dort kleineren Ätzrate - längerer Diffusionsweg!) im wesentlichen eben zurückbleibt und diese Gräben ausfüllt, um Leiterbahnen oder Isolatorbahnen zu bilden.

Bei dem erfindungsgemäßen Verfahren können sich in den Gräben außer Metallen, wie beispielsweise Kupfer oder Aluminium, auch polykristallines Silizium und polykristalline Silizide (wie beispielsweise Wolframsilizid) oder auch Siliziumdioxid (Si0₂) als Beschichtung 3 befinden. Ist die Beschichtung Si0₂, dann besteht die Schicht 2, in der die Gräben vorgesehen sind, bevorzugt und vor allem aus Silizium.

Es versteht sich, daß bei dem erfindungsgemäßen Verfahren solche Ätzmittel verwendet werden, die bezüglich des als Beschichtung 3 bildenden Materials eine Ätzwirkung entfalten.

Bei dem erfindungsgemäßen Verfahren wird also so gearbeitet, daß das Ätzmittel (eine Flüssigkeit) in einem kontinuierlichen Volumenstrom aufgebracht wird, der die gesamte zu bearbeitende Oberfläche des Halbleitersubstrates bedeckt und entlang dieser strömt, was dadurch erreicht wird, daß das Halbleitersubstrat in Rotation versetzt wird.

Dadurch, daß bei dem erfindungsgemäßen Verfahren nicht wie im Stand der Technik mit aufgesprühten oder tropfenweise aufgebrachten Ätzflüssigkeiten gearbeitet, sondern die Ätzflüssigkeit in einem kontinuierlichen Volumenstrom vorzugsweise mit einer Strömungsrate von nicht unter 1 l/min, aber über 0,4 l/min auf das Substrat aufgebracht wird, ist das Wiedergewinnen und Wiederverwerten der Ätzflüssigkeit, gegebenenfalls nach einer Aufbereitung derselben, mit besonderem Vorteil durchführbar, da mehr Volumen zur Handhabung beim Durchführen der Ätzflüssigkeit in einem Kreislauf, in dem sie wieder aufbereitet wird, zur Verfügung steht.

Besonders vorteilhaft hat es sich beim erfindungsgemäßen Verfahren herausgestellt, wenn die Düse relativ zu der Drehachse des sich drehenden Substrates nicht stillsteht sondern sich gegenüber dieser bewegt. Dabei sind Bewegungsbahnen der Düse, aus welcher der Volumenstrom an Ätzflüssigkeit austritt, die sich entlang eines Durchmessers oder einer Sekante bezüglich des Substrates bewegen, von besonderem Vorteil. Bei praktischen Versuchen hat sich herausgestellt, daß eine Düsenbahn, die sich mit geringem Abstand vom Rotationszentrum des zu planarisierenden Substrates vorbeibewegt, also den Volumenstrom der Ätzflüssigkeit bezüglich des Außenumfangsrandes entlang einer Sekante bewegt, besonders gute Ergebnisse liefert. Dabei hat es sich auch als günstig erwiesen, wenn die Bewegung der Düse und damit die Bewegung des aus ihr austretenden Volumenstromes an Ätzflüssigkeit relativ zu dem sich drehenden Substrat mit größerer Geschwindigkeit erfolgt.

Wenn der Volumenstrom relativ zu dem sich drehenden Substrat entlang einer Bahn bewegt wird, also der Bereich, in dem die Ätzflüssigkeit auf das rotierende Substrat auftritt, die im wesentlichen einer Sekante entspricht, dann ergibt sich der Vorteil, daß im Rotationszentrum keine ruhende Flüssigkeitsmenge vorliegt, sondern sich die Schichte oder der Film aus Ätzflüssigkeit gleichmäßig über die gesamte Oberfläche bewegt und über die Oberfläche entlangströmt.

Als besonders vorteilhaft beim der Ätzen von Metallen (z.B. Kupfer) zeigt sich die Verwendung spezieller Ätzmischungen, die es ermöglichen in nur einem Ätzschritt das auf dem Feld befindliche Material 3a, den oberen Teil des im Graben befindlichen Materials 3b und den auf dem Feld befindlichen Teil 7a der Sperrschicht (Fig. 3a-4d) zu entfernen. Die Ätzmischung besteht neben dem Lösungsmittel (Wasser) aus zwei Komponenten A und B.

Komponente A ist ein Oxidationsmittel (z.B. Salpetersäure, Kalium-Bichromat, Chromschwefelsäure, Ammonium- oder Natrium-Persulfat). Ammonium- oder Natrium-Persulfat sind besonders gut geeignet.

Komponente B ist eine Säure oder ein Salz mit der bzw. mit dem das oxidierte Material der Sperrschicht ein (leicht) lösliches Salz oder einen (leicht) löslichen Komplex bildet (z.B. eine Halogenwasserstoffsäure (z.B. Flußsäure), Oxalsäure). Besonders gut geeignet ist Flußsäure.

Zusätzlich ergibt die Beimengung einer Komponente C eine wesentliche Vergleichmäßigung des Ätzergebnisses. Dieser Zusatz (Komponente C) verringert die Ätzgeschwindigkeit (bei sonst gleicher Konzentration der Komponenten A, B und gleicher Temperatur) und vergleichmäßigt so das Ergebnis. Die Komponente C verringert die Dielektrizität der Ätzlösung. Hierfür geeignet sind ein- oder mehrwertige Alkohole oder deren Derivate (z.B. Methanol, Ethanol, Isopropanol, Glykol, Glyzerin, Essigsäure-Ethylester, Polyethylenglyol). Besonders geeignet hierfür sind mehrwertige Alkohole oder deren Derivate (z.B. Glykol, Glyzerin, Polyethylenglyol).

Die Wirkung dieser Ätzmischungen sei anhand der Figuren 3a-d bzw. 4a-d für das Herstellen von Leiterbahnen beschrieben, die einen schematischen Querschnitt eines Halbleitersubstrates darstellen.

In der Isolatorschicht 2, die z.B. aus SiO₂ besteht, ist in einer Vertiefung (Graben oder Kontaktloch) und auf dem Feld zuerst eine ca. 10 nm dicke Sperrschicht 7a, 7b (z.B. Titan, Tantal, Titannitrid, Tantalnitrid oder Chrom) und darauf eine Schicht 3a, 3b eines gut leitendes Metalls (z.B. Kupfer) aufgetragen (Fig. 3a, 4a). In Fig. 4a ist die Schicht 3a des gut leitenden Metall etwas dicker. Der Grund dafür kann z.B. ein unregelmäßiger Auftrag der Metallschicht auf einem Halbleitersubstrat (Wafer) sein.

Nach fortgeschrittenem Ätzen (Fig. 3b, 4b) wird bei bestimmten Bereichen des Halbleitersubstrates (Wafers) bereits die auf dem Feld befindliche Sperrschicht 7a freigelegt (Fig. 3b) während bei anderen Bereichen noch des Ätzen der Metallschicht 3a und des oberen Teil des Bereiches 3b stattfindet.

In verblüffender Weise zeigte sich nun, daß in dem Moment in dem ein Angriff auf die Sperrschicht 7a beginnt die Metallschicht 3b kaum mehr angegriffen wird.

Bei weiterem Angriff des Ätzmediums (Fig. 3c, 4c) ist bei bestimmten Bereichen des Halbleitersubstrates (Wafers) die auf dem Feld befindliche Sperrschicht entfernt und bereits das Feld freigelegt (Fig. 3c), während bei anderen Bereichen erst die auf dem Feld befindliche Sperrschicht 7a freigelegt wird (Fig. 4c).

Die Anwendung der erfindungsgemäßen Ätzmittel kann mit jedem Naßätzverfahren erfolgen, d.h. nicht nur mit dem Rotationsätzverfahren sondern z.B. auch im Ätzbad.

Nachstehend werden einige Beispiele für das erfindungsgemäße Verfahren bzw. die erfindungsgemäßen Ätzmittel angegeben:

### Beispiel 1:

Material 3 im Graben: Kupfer
Material 2, in das der Graben geätzt wurde: Si0₂
Breite des Grabens unter 1 µm (1,0 µm)
Tiefe des Grabens: 0,1 bis 1,0 µm (0,3 µm)
Dicke der Schicht 3a über dem Feld: < 1 µm (0,5 µm)
   - Ätzmittel:: 20 Vol.-Teile H₃P0₄ konzentriert,
   1 Vol.-Teil HNO₃ konzentriert,
   1 Vol.-Teil Wasser,
   zusätzlich etwas Netzmittel
Drehzahl: 300 bis 3000 U/min
Volumenstrom des Ätzmittels: 1 l/min
Temperatur: Raumtemperatur bis 50°C
Ätzrate: 1 bis 10 µm/min

### Beispiel 2:

Material 3 im Graben: Aluminium
Material 2, in das der Graben geätzt wurde: Si0₂
Breite des Grabens: < 2 µm (1,0 µm)
Tiefe des Grabens: 0,1 bis 1,0 µm (0,5 µm)
Dicke der Materialschicht 3a am Feld: < 1 µm (0,5 µm)
   - Ätzmittel:: 20 Vol.-Teile H₃P0₄ konzentriert,
   1 Vol.-Teil HNO₃ konzentriert,
   1 Vol.-Teil H₂0 konzentriert,
   0,5 Vol.-Teile HCl konzentriert,
   0,5 Vol.-Teile einer organischen Säure, bevorzugt ei
   ne kurzkettige, aliphatische Säure, wie Essigsäure)
   0,5 Vol.-Teile eines Alkohols (bevorzugt ein kurzkettiger Alkohol, wie Ethanol) und Netzmittel
Drehzahl: 100 bis 3000 U/min
Volumenstrom des Ätzmittels: 1 l/min
Temperatur: Raumtemperatur bis 50°C
Ätzrate: 1 bis 10 µm/min

### Beispiel 3:

Material 3 im Graben:
   polykristallines Silizium oder ein polykristallines Silizid von Wolfram, Titan, Platin oder Gold
Material, in das der Graben geätzt wurde: Silizium
Breite des Grabens: 1 µm
Tiefe des Grabens: 0,1 bis 1,0 µm
Dicke der Materialschicht 3a am Feld: 1 µm
   - Ätzmittel:: konzentrierte Flußsäure und
   konzentrierte Salpetersäure als Hauptbestandteil und zusätzlich
   eine organische Säure ähnlich Beispiel 2,
   konzentrierte Phosphorsäure und konzentrierte Schwefelsäure als zusätzliche Bestandteile des Ätzmittels
Drehzahl: 100 bis 3000 U/min
Volumenstrom: 1 l/min
Temperatur: Raumtemperatur bis 50°C
Ätzrate: 1 bis 4 µm/min

### Beispiel 4:

Material 3b im Graben: Si0₂
Material, in das der Graben geätzt wurde: Silizium
Breite des Grabens: 1 µm (1 µm)
Tiefe des Grabens: 0,1 bis 1,0 µm
Dicke der Materialschicht 3a am Feld: 1 µm
   - Ätzmittel:: Hauptbestandteile:
   Konzentrierte Flußsäure oder eine konzentrierte Ammoniumfluorid (NH₄F)-Lösung, sowie Phosphorsäure und/oder Polyethylenglykol als viskositätserhöhende Zusätze
Drehzahl: 100 bis 3000 U/min
Volumenstrom des Ätzmittels: 1 l/min
Temperatur: Raumtemperatur bis 50°C
Ätzrate: 1 bis 10 µm/min

### Beispiel 5:

Material 3 im Graben: Kupfer
Sperrschicht 7: Tantalnitrid
Material 2, in das der Graben geätzt wurde: Si0₂
Breite des Grabens < 1 µm (0,5 µm)
Tiefe des Grabens: 0,1 bis 1,0 µm (0,2 µm)
Dicke der Schicht 3a über dem Feld: < 1 µm (0,5 µm)
   - Ätzmittel:: 2 Vol.-Teile Na₂S0₅-Lösung (50%-ig)(Komponente A),
   0,5 Vol.-Teile HF konzentriert (Komponente B),
   8 Vol.-Teile Wasser,
Drehzahl: 300 bis 3000 U/min
Volumenstrom des Ätzmittels: 1 l/min
Temperatur: Raumtemperatur
Ätzrate: 1 µm/min

### Beispiel 6:

Material 3 im Graben: Kupfer
Sperrschicht 7: Tantalnitrid
Material 2, in das der Graben geätzt wurde: Si0₂
Breite des Grabens < 1 µm (0,5 µm)
Tiefe des Grabens: 0,1 bis 1,0 µm (0,2 µm)
Dicke der Schicht 3a über dem Feld: < 1 µm (0,5 µm)
   - Ätzmittel:: 2 Vol.-Teile Na₂S0₅-Lösung (50%-ig)(Komponente A),
   0,5 Vol.-Teile HF konzentriert (Komponente B),
   1,5 Vol.-Teile Glycerin (Komponente C),
   8 Vol.-Teile Wasser,
Drehzahl: 300 bis 3000 U/min
Volumenstrom des Ätzmittels: 1 l/min
Temperatur: Raumtemperatur
Ätzrate: 0,5 µm/min

Die Ausführungsbeispiele zeigen, daß für das Planarisieren, also den Übergang von der in Fig. 2b dargestellten Konfiguration in die in Fig. 2c dargestellte Konfiguration, in der die Beschichtung ausschließlich im Graben vorhanden ist, ein rein naßchemisches Verfahren ausreicht. Zwar ist die Planarität, wie Fig. 2c zeigt, nach Anwendung des erfindungsgemäßen Verfahrens nicht vollkommen, da das Material 3 im Graben in der Schicht 2 eine geringfügig konkave Oberfläche aufweist. Jedoch ist die Planarität für die angestrebten Zwecke der Halbleitertechnik, nämlich als Leiter oder Isolatorbahnen zu dienen (je nach dem Material 3 im Graben) völlig hinreichend.

Zusammenfassend kann ein Ausführungsbeispiel der Erfindung wie folgt dargestellt werden:

Bei einem Verfahren zum Planarisieren von Halbleitersubstraten, bei dem eine Schicht, die auf ein Gräben und/oder Kontaktlöcher aufweisendes Halbleitersubstrat aufgetragen worden ist, derart entfernt wird, daß die Schicht ausschließlich im Bereich der Gräben oder Kontaktlöcher zurückbleibt, wird, statt wie im Stand der Technik, das Ätzmedium tropfenweise aufgebracht, das Ätzmedium in einem kontinuierlichen Strom mit einer Strömungsrate von wenigstens 0,4 l/min aufgebracht, so daß das Ätzmedium die gesamte Oberfläche des zu planarisierenden Halbleitersubstrates bedeckt. Durch diese Arbeitstechnik entsteht eine differenzierte Ätzrate, wobei die Ätzgeschwindigkeit im Bereich der Felder zwischen den Gräben oder Kontaktlöchern größer ist als im Bereich der Gräben selbst, so daß im Ergebnis die auf das Halbleitersubstrat aufgetragene Beschichtung rascher weggeätzt wird, als im Bereich der Gräben und schließlich Material nur im Bereich der Gräben oder Kontaktlöcher zurückbleibt.

## Patentansprüche

1. Verfahren zum Planarisieren von Substraten der Halbleitertechnik, bei dem eine Beschichtung von einer Fläche des Substrates so weit entfernt wird, dass die Beschichtung ausschließlich im Bereich von wenigstens einem Graben und/oder wenigstens einem Kontaktloch in dem Substrat zurückbleibt, mit Hilfe eines Ätzmittels, wobei das Halbleitersubstrat in Rotation versetzt ist, **dadurch gekennzeichnet, dass** das Ätzmittel in einem kontinuierlichen Fluß, ohne Tropfenbildung, auf die zu planarsierende Oberfläche aufgetragen wird und, dass das Ätzmittel mit einem Fluß von wenigstens 0,4 l/min, vorzugsweise 1 l/min, aufgetragen wird.

2. Verfahren nach Anspruch 1, **dadurch gekennzeichnet, dass** ein Ätzmittel verwendet wird, das einen seine Viskosität erhöhenden Zusatz enthält.

3. Verfahren nach einem der Ansprüche 1 oder 2, **dadurch gekennzeichnet, dass** durch Planarisieren eine Schicht aus einem Metall entfernt wird.

4. Verfahren nach einem der Ansprüche 1 oder 2, **dadurch gekennzeichnet, dass** durch das Planarisieren eine Schicht aus polykristallinem Silizium entfernt wird.

5. Verfahren nach einem der Ansprüche 1 oder 2, **dadurch gekennzeichnet, dass** durch das Planarisieren eine Schicht aus einem polykristallinem Silizid, vornehmlich einem Silizid von Wolfram, Titan, Platin oder Gold entfernt wird.

6. Verfahren nach einem der Ansprüche 1 oder 2, **dadurch gekennzeichnet, dass** durch das Planarisieren eine Schicht aus Siliziumdioxid entfernt wird.

7. Verfahren nach Anspruch 3, **dadurch gekennzeichnet, dass** ein Ätzmittel verwendet wird, das Salpetersäure enthält.

8. Verfahren nach Anspruch 7, **dadurch gekennzeichnet, dass** ein Ätzmittel verwendet wird, das eine weitere Säure enthält.

9. Verfahren nach einem der Ansprüche 5 oder 6, **dadurch gekennzeichnet, dass** ein Ätzmittel verwendet wird, das Flusssäure oder Ammoniumfluorid enthält.

10. Verfahren nach einem der Ansprüche 2 bis 9, **dadurch gekennzeichnet, dass** ein Ätzmittel verwendet wird, das als viskositätserhöhenden Zusatz Phosphorsäure, vorzugsweise o-Phosphorsäure und/oder Polyethylenglykol enthält.

11. Verfahren nach einem der Ansprüche 1 bis 10, **dadurch gekennzeichnet, dass** ein Ätzmittel verwendet wird, das ein Netzmittel enthält.

12. Verfahren nach Anspruch 11, **dadurch gekennzeichnet, dass** das Netzmittel eine vorzugsweise niedrigkettige, aliphatische Carbonsäure, wie beispielsweise Essigsäure, ist.

13. Verfahren nach Anspruch 12, **dadurch gekennzeichnet, dass** ein Ätzmittel verwendet wird, das einen Alkohol, vorzugsweise einen niedrigen, aliphatischen Alkohol, wie Ethanol enthält.

14. Verfahren nach einem der Ansprüche 1 bis 13, **dadurch gekennzeichnet, dass** der kontinuierliche Fluß des Ätzmittels beim Planarisieren relativ zu dem sich drehenden Substrat bewegt wird.

15. Verfahren nach Anspruch 14, **dadurch gekennzeichnet, dass** der Fluß längs einer Bahn relativ zu dem sich drehenden Substrat bewegt wird, die durch den Rotationsmittelpunkt geht.

16. Verfahren nach Anspruch 14, **dadurch gekennzeichnet, dass** der Fluß längs einer Bahn bewegt wird, die im Abstand von dem Rotationsmittel punkt des Substrates beim Planarisieren verläuft.

17. Verfahren nach einem der Ansprüche 14 bis 16, **dadurch gekennzeichnet, dass** die Bahn des Flusses eine gerade Bahn ist.

18. Verfahren nach einem der Ansprüche 14 bis 16, **dadurch gekennzeichnet, dass** die Bahn des Flusses eine gekrümmte Bahn ist.

19. Verfahren nach einem der Ansprüche 1 bis 18, **dadurch gekennzeichnet, dass** die Ätzflüssigkeit, nachdem sie vom Substrat abgeströmt ist, gesammelt und gegebenenfalls nach einer Wiederaufarbeitung erneut zum Planarisieren rezykliert wird.

## Claims

1. A method for planarizing substrates in semiconductor technology, in which a coating is removed from a surface of the substrate to such an extent that the coating remains exclusively in the region of at least one groove and/or at least one contact hole in the substrate, with the help of an etchant, with the semiconductor substrate being made to rotate, **characterized in that** the etchant is applied in a continuous flow, without drop generation, to the surface to be planarized and the etchant is applied with a flow of at least 0.4 I/min, preferably 1 l/min.

2. A method according to claim 1, **characterized in that** an etchant is used which contains an additive that increases its viscosity.

3. A method according to one of the claims 1 or 2, **characterized in that** a layer made of a metal is removed by planarizing.

4. A method according to one of the claims 1 or 2, **characterized in that** a layer made of polycrystalline silicon is removed by planarizing.

5. A method according to one of the claims 1 or 2, **characterized in that** a layer made of a polycrystalline silicide, mainly a silicide of tungsten, titanium, platinum or gold, is removed by planarizing.

6. A method according to one of the claims 1 or 2, **characterized in that** a layer made of silicon dioxide is removed by planarizing.

7. A method according to claim 3, **characterized in that** an etchant is used which contains nitric acid.

8. A method according to claim 7, **characterized in that** an etchant is used which contains a further acid.

9. A method according to one of the claims 5 or 6, **characterized in that** an etchant is used which contains hydrofluoric acid or ammonium fluoride.

10. A method according to one of the claims 2 to 9, **characterized in that** an etchant is used which contains phosphoric acid, preferably o-phosphoric acid and/or polyethylene glycol, as an additive to increase viscosity.

11. A method according to one of the claims 1 to 10, **characterized in that** an etchant is used which contains a wetting agent.

12. A method according to claim 11, **characterized in that** the wetting agent is preferably a low-chain, aliphatic carboxylic acid such as ethanoic acid for example.

13. A method according to claim 12, **characterized in that** an etchant is used which contains an alcohol, preferably a lower aliphatic alcohol such as ethanol.

14. A method according to one of the claims 1 to 13, **characterized in that** the continuous flow of the etchant during planarizing is moved relative to the rotating substrate.

15. A method according to claim 14, **characterized in that** the flow is moved along a path relative to the rotating substrate which passes through the center of rotation.

16. A method according to claim 14, **characterized in that** the flow is moved along a path which extends at a distance from the center of rotation of the substrate during planarizing.

17. A method according to one of the claims 14 to 16, **characterized in that** the path of the flow is a straight path.

18. A method according to one of the claims 14 to 16, **characterized in that** the path of the flow is a curved path.

19. A method according to one of the claims 1 to 18, **characterized in that** the etchant, is collected after it has flown off from the substrate and is optionally recycled for renewed planarizing after reprocessing.

## Revendications

1. Procédé de planarisation de substrats dans la production de semi-conducteurs, dans lequel un revêtement d'une surface du substrat est éliminé jusqu'à ce que le revêtement subsiste uniquement au niveau d'au moins un creux et/ou d'au moins un trou de contact dans le substrat, à l'aide d'un produit d'attaque chimique, le substrat semi-conducteur étant mis en rotation, **caractérisé en ce que** le produit d'attaque chimique est appliqué en un flux continu, sans formation de gouttes, sur la surface à planariser, et **en ce que** le produit d'attaque chimique est appliqué à un débit d'au moins 0,41/min, de préférence de 11/min.

2. Procédé selon la revendication 1, **caractérisé en ce que** le produit d'attaque chimique contient un additif qui accroît sa viscosité.

3. Procédé selon l'une des revendications 1 ou 2, **caractérisé en ce qu'**une couche d'un métal est éliminée par la planarisation.

4. Procédé selon l'une des revendications 1 ou 2, **caractérisé en ce qu'**une couche de silicium polycristallin est éliminée par la planarisation.

5. Procédé selon l'une des revendications 1 ou 2, **caractérisé en ce qu'**une couche d'un siliciure polycristallin, de préférence une couche de siliciure de tungstène, de titane, de platine ou d'or, est éliminée par la planarisation.

6. Procédé selon l'une des revendications 1 ou 2, **caractérisé en ce qu'**une couche de dioxyde de silicium est éliminée par la planarisation.

7. Procédé selon la revendication 3, **caractérisé en ce que** le produit d'attaque chimique utilisé contient de l'acide nitrique.

8. Procédé selon la revendication 7, **caractérisé en ce que** le produit d'attaque chimique utilisé contient un autre acide.

9. Procédé selon l'une des revendications 5 ou 6, **caractérisé en ce que** le produit d'attaque chimique utilisé contient de l'acide fluorhydrique ou du fluorure d'ammonium.

10. Procédé selon l'une des revendications 2 à 9, **caractérisé en ce que** le produit d'attaque chimique contient comme additif accroissant sa viscosité de l'acide phosphorique, de préférence de l'acide orthophosphorique, et/ou du polyéthylène-glycol.

11. Procédé selon l'une des revendications 1 à 10, **caractérisé en ce que** le produit d'attaque chimique utilisé contient un agent mouillant.

12. Procédé selon la revendication 11, **caractérisé en ce que** l'agent mouillant est un acide carboxylique aliphatique à chaîne courte, par exemple de l'acide acétique.

13. Procédé selon la revendication 12, **caractérisé en ce que** le produit d'attaque chimique utilisé contient un alcool, de préférence un alcool aliphatique simple tel que l'éthanol.

14. Procédé selon l'une des revendications 1 à 13, **caractérisé en ce que** le flux continu du produit d'attaque chimique lors de la planarisation est déplacé par rapport au substrat en rotation.

15. Procédé selon la revendication 14, **caractérisé en ce que** le flux est déplacé le long d'une trajectoire par rapport au substrat en rotation qui passe par le centre de rotation.

16. Procédé selon la revendication 14, **caractérisé en ce que** le flux est déplacé le long d'une trajectoire qui passe à distance du centre de rotation du substrat lors de la planarisation.

17. Procédé selon l'une des revendications 14 à 16, **caractérisé en ce que** la trajectoire du flux est une trajectoire rectiligne.

18. Procédé selon l'une des revendications 14 à 16, **caractérisé en ce que** la trajectoire du flux est une trajectoire courbe.

19. Procédé selon l'une des revendications 1 à 18, **caractérisé en ce que** le liquide d'attaque chimique, après s'être écoulé du substrat, est recueilli et éventuellement recyclé après retraitement pour servir à nouveau à la planarisation.
